# EUROPEAN PATENT APPLICATION

(11) **EP 2 166 824 A1**
(43) Date of publication of application: **24.03.2010**
(21) Application number: 09170571.5
(22) Date of filing: 17.09.2009
(51) Int. Cl.: H05K 1/02, H05K 3/28, H05K 3/22, G01R 19/00, B62D 5/00, H05K 3/46

(54) **Multilayer circuit board and motor driving circuit board**

(30) Priority: 19.09.2008 JP 2008240246
(71) Applicant: JTEKT CORPORATION, Chuo-ku Osaka-shi Osaka 542-8502 (JP)
(72) Inventor: Nakai, Motoo, Osaka-shi, Osaka 542-8502 (JP)
(74) Representative: TBK-Patent

(57) **Abstract**

A multilayer circuit board (100) serving as a motor driving circuit board is structured such that conductors of a first layer (110), a second layer (120), a third layer (130), and a fourth layer (140), which serve as conductor layers provided below an empty space to be occupied by a sealing material (170) when the sealing material (170) is charged onto a lower surface of a shunt resistor (12) serving as an electronic component having a large conductor surface, do not exist in a part facing the empty space. With this structure, it is possible to ensure that a capacitor is not formed between the circuit board (100) and the shunt resistor (12) without the need for an inflow prevention tool.

As a result, an accurate current detection signal can be obtained reliably.

## Description

### BACKGROUND OF THE INVENTION

### 1. Field of the Invention

The invention relates to a multilayer circuit board and to a motor driving circuit board used in an electric power steering apparatus, employing the multilayer circuit board.

### 2. Description of the Related Art

An electric power steering apparatus for a vehicle drives a steering assist motor in accordance with a steering torque applied to a steering wheel by a driver, a vehicle speed, and so on, such that a favorable steering assist force is obtained. The steering assist motor is driven by a motor driving circuit built into an electronic control unit. When driving the steering assist motor, the motor driving circuit controls great power between approximately 500 and 2000 W. The electronic control unit will be referred to hereafter as an ECU.

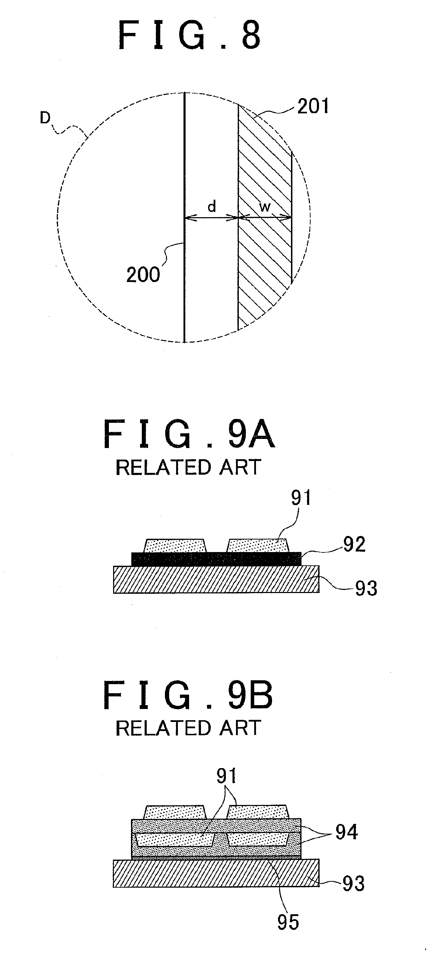

At this time, the motor driving circuit generates heat, and therefore, to prevent malfunctions and damage in the ECU caused by the generated heat, the motor driving circuit is packaged on a circuit board exhibiting favorable thermal conductivity. As shown in FIG. 9A, for example, the motor driving circuit is packaged on a metallic circuit board constructed by forming one copper conductor layer 91 and one resin insulating layer 92 on an aluminum metallic substrate 93 (heat sink).

Electronic components can only be packaged on one side of the circuit board shown in FIG. 9A. More specifically, electronic components can only be packaged on the conductor layer 91, and therefore a large area of the ECU is occupied by the circuit board. As one method of reducing the substrate area, the circuit board may be formed in multiple layers, as shown in FIG. 9B. A ceramic multilayer substrate shown in FIG. 9B is formed by laminating the copper conductor layer 91 and a ceramic insulating layer 94 in multiple layers and adhering the laminated layers to the aluminum metallic substrate 93 (heat sink) using an adhesive 95. By forming the circuit board from multiple layers in this manner, the substrate area can be reduced.

The following related art is available. International Patent Application 2008/078739 discloses a constitution for a multilayer circuit board in which an electronic component such as a power metal oxide semiconductor field effect transistor (MOSFET) is caused to radiate heat by forming a conductor layer on an inner surface using copper plating or the like and providing a heat dissipating via filled with a resin in the interior. Further, Japanese Patent Application Publication No. 2006-74014 (JP-A-2006-74014) discloses a constitution for a multilayer circuit board in which an uppermost layer microstrip line is formed not to overlap a conductor layer on a lower layer and thereby to overlap a GND pattern on an even lower layer.

Electronic components carried on a multilayer motor driving circuit board as described above include a semiconductor bear chip laid by wire bonding and a soldered current detecting shunt resistor. To protect these electronic components and wires, a normal substrate is sealed by an insulating resin material. At this time, the sealing insulating material (sealing material) may flow into a gap between the shunt resistor and the substrate. As a result, a capacitor may be formed on either side of the sealing material, which is a dielectric, causing disturbances during current detection.

In a conventional method relating to this point, a component such as an inflow prevention tool may be newly attached to the periphery of the shunt resistor to prevent inflow of the sealing material, but due to the cost of the inflow prevention tool itself and the need for a process to attach the tool, the manufacturing cost of the substrate increases.

### SUMMARY OF THE INVENTION

It is therefore an object of the invention to provide a multilayer circuit board structured so that a capacitor such as that described above is not formed between the circuit board and a shunt resistor on either side of a sealing material even without attaching a new component such as a sealing material inflow prevention tool, and a motor driving circuit board for an electric power steering apparatus that employs the multilayer circuit board.

A multilayer circuit board formed by laminating conductor layers and insulating layers alternately according to a first aspect of the invention includes: a conductor that has a surface substantially parallel to a top surface of the multilayer circuit board, and that is connected to an uppermost conductor layer such that a gap is formed between the conductor and the top surface of the multilayer circuit board; and a sealing material serving as a dielectric that is charged into a space including a periphery of the conductor and the gap, wherein, in the conductor layers, a conductor is not formed in a position facing the gap in a lamination direction of the conductor layers and the insulating layers.

In the multilayer circuit board according to this aspect, the conductor layers do not include a conductor in the position facing the gap in the lamination direction of the conductor layers and insulating layers to ensure that a capacitor is not formed on either side of the sealing material serving as the dielectric that is charged into the space including the periphery of the conductor and the gap, i.e. between the substantially parallel surface of the conductor to the top surface of the multilayer circuit board and the conductor layers positioned opposite the conductor via the gap. In so doing, it is possible to ensure that a capacitor is not formed between the circuit board and the conductor on either side of the sealing material without attaching a new component such as an inflow prevention tool for preventing the sealing material from entering the gap.

Further, in the multilayer circuit board according to the aspect described above, in at least one of the conductor layers, a part facing the gap in the lamination direction of the conductor layers and the insulating layers may be removed.

According to this aspect, the part facing the gap in the lamination direction of the conductor layers and the insulating layers is removed from at least one of the conductor layers, and it is therefore possible to ensure that a capacitor is not formed between the conductor and the conductor layer on either side of the sealing material.

A motor driving circuit board for an electric power steering apparatus, which is formed by laminating conductor layers and insulating layers alternately, according to a second aspect of the invention includes: a current detecting resistor that has a surface substantially parallel to a top surface of the motor driving circuit board, and that is connected to an uppermost conductor layer such that a gap is formed between the current detecting resistor and the top surface of the motor driving circuit board; and a sealing material serving as a dielectric that is charged into a space including a periphery of the resistor and the gap, wherein, in the conductor layers, a conductor is not formed in a part facing the gap in a lamination direction of the conductor layers and the insulating layers.

According to the second aspect, the effects of the first aspect can be exhibited in a motor driving circuit board, and since the current detecting resistor, which is particularly likely to be affected when the sealing material forms a capacitor, is not affected in this manner, accurate current detection can be performed reliably.

### BRIEF DESCRIPTION OF THE DRAWINGS

The features, advantages, and technical and industrial significance of this invention will be described in the following detailed description of example embodiments of the invention with reference to the accompanying drawings, in which like numerals denote like elements, and wherein:
FIG. 1 is a partial sectional view showing a multilayer circuit board according to an embodiment of the invention;
FIG. 2 is a circuit diagram of the multilayer circuit board according to this embodiment;
FIG. 3 is a partial exploded perspective view showing the structure of each layer of the multilayer circuit board according to this embodiment;
FIG. 4 is a schematic sectional view and a schematic plan view of a multilayer circuit board formed with a resist film;
FIG. 5 is a view illustrating how a resist film is likely to peel away from the vicinity of a circuit conductor in a multilayer circuit board according to the related art during a compression bonding process;
FIG. 6 is a view illustrating how a resist film is unlikely to peel away from the vicinity of a circuit conductor in a multilayer circuit board according to a modified example of this embodiment during a compression bonding process;
FIG. 7 is a plan view showing a substrate end portion and a wiring conductor according to a modified example of this embodiment;
FIG. 8 is a plan view showing a substrate end portion and a wiring conductor according to another modified example of this embodiment;
FIG. 9A is a sectional view showing a circuit board according to the related art; and
FIG. 9B is a sectional view showing a circuit board according to the related art.

### DETAILED DESCRIPTION OF EMBODIMENTS

A multilayer circuit board according to this embodiment is a motor driving circuit board for an electric power steering apparatus, which is used when built into an ECU of the electric power steering apparatus.

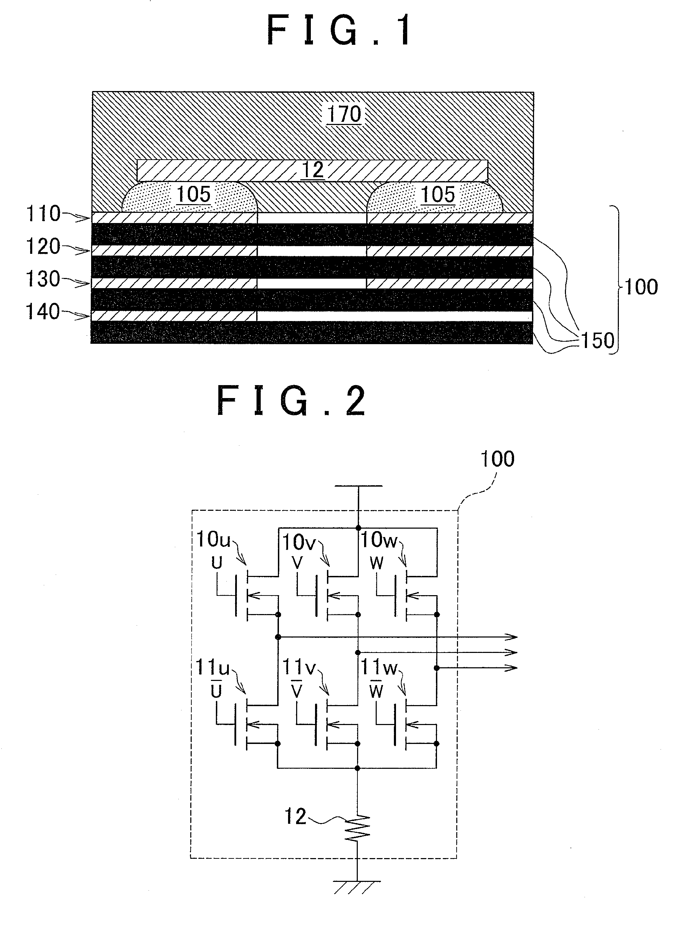

The ECU includes a motor control circuit that calculates an amount of a drive current supplied to a steering assist motor, and a motor driving circuit that drives the steering assist motor by controlling a large current. A current flowing through the motor control circuit when operative and an amount of heat generated thereby are both small, whereas a current flowing through the motor driving circuit when operative and an amount of heat generated thereby are both large. The motor driving circuit is packaged on a motor driving circuit board, and the motor control circuit is packaged on a separate circuit board. The structure of a multilayer circuit board serving as a motor driving circuit board will be described below with reference to FIGS. 1 to 3.

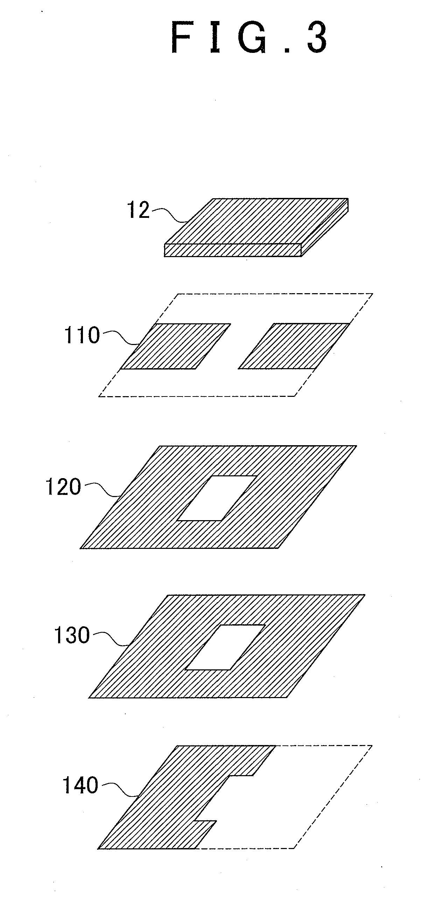

FIG. 1 is a partial sectional view showing a multilayer circuit board according to an embodiment of the invention. FIG. 2 is a circuit diagram of the multilayer circuit board. FIG. 3 is a partial exploded perspective view showing the structure of each layer of the multilayer circuit board.

A multilayer circuit board 100 shown in the drawings has a four-layer structure in which a first layer (top layer) 110, a second layer 120, a third layer 130 and a fourth layer 140, which serve as conductor layers, and insulating layers 150 provided between the respective conductor layers are formed by thermal compression bonding. The conductor layer is formed from a highly conductive metal such as copper, and the insulating layer is formed from so-called pre-preg, which is a composite formed by impregnating glass fiber with an insulating resin material. Note that an aluminum metallic base, not shown in the drawings, is subjected to thermal compression bonding onto a lower surface of the multilayer circuit board 100 for the purpose of heat dissipation.

The top surface of the multilayer circuit board 100 carries a shunt resistor 12, which is a current detection resistor, and six MOSFETs 10u, 10v, 10w, 11u, 11v, 11w, not shown in FIG. 1. Upper connection terminals of the MOSFETs are wire-bonded to wiring conductors formed from aluminum wires and provided in predetermined positions on the first layer 110. The shunt resistor 12 is soldered to the wiring conductors provided in predetermined positions on the first layer 110 by solder 105.

As shown in FIG. 2, drain terminals of the MOSFETs 10u, 10v, 10w are connected to a positive electrode of a power supply portion, not shown in the drawing, and source terminals thereof are connected to an input terminal of a corresponding motor phase. Source terminals of the MOSFETs 11u, 11v, 11w are connected to a negative electrode (ground electrode) of the power supply portion, not shown in the drawing, via the shunt resistor 12, and drain terminals thereof are connected to the input terminal of the corresponding motor phase.

To protect the electronic components, wires, and the like on the multilayer circuit board 100, sealing is implemented over the entire substrate top surface using a sealing material 170 made of an insulating resin. The sealing material 170 is an insulating resin such as an epoxy resin, which is applied in a liquid state and then thermally hardened to protect the sealed electronic components and wires from physical impacts, moisture, and so on. Accordingly, the sealing material 170 is applied to adhere tightly to the electronic components without gaps and charged into a gap (space) formed by a region surrounded by a lower surface of the shunt resistor 12, the two ends of which are soldered by the solder 105, the top surface of the multilayer circuit board 100, and the solder 105.

However, the sealing material 170 has a predetermined dielectric constant, and therefore, when the sealing material 170 is charged onto the lower surface of the shunt resistor 12, a large current flows into the multilayer circuit board 100. As a result, a capacitor may be formed between the lower surface of the shunt resistor 12, which serves as a conductor having a comparatively large surface area, and the conductor disposed therebelow, which has a comparatively large surface area. The shunt resistor 12 is used for current detection, and therefore, if this capacitor is formed, a large problem arises in that irregularities occur in a current detection signal.

To solve this problem, in the multilayer circuit board 100 according to this embodiment, the conductors of the first layer 110, second layer 120, third layer 130, and fourth layer 140, which serve as the conductor layers positioned below the space to be occupied by the sealing material 170 when the sealing material 170 is charged onto the lower surface of the shunt resistor 12, or in other words the empty space prior to charging of the sealing material 170, do not exist in the parts facing the position of this empty space. This will now be described in detail with reference to FIG. 3.

FIG. 3 is a schematic exploded perspective view showing the shape of the conductor layers below the shunt resistor. As shown in FIG. 3, a wiring conductor of the first layer 110 is disposed below the shunt resistor 12 in the vicinity of the two ends thereof via the solder 105, not shown in FIG. 3, in a lamination direction of the respective layers. Meanwhile, near the center of the shunt resistor 12, or in other words a part positioned below the empty space to be occupied by the sealing material 170 prior to charging of the sealing material 170 in the lamination direction of the respective layers, the wiring conductor of the first layer 110 does not exist.

A wiring conductor of the second layer 120 functions here as a ground wire (GND wire), and even though the second layer 120 forms a solid copper foil region having a lowered normal resistance value in order to suppress noise, or in other words a wiring region having a large surface area, the second layer 120 is shaped such that the conductor is removed only from the part positioned below and facing the empty space in the lamination direction of the respective layers, whereby a hole is formed in the center of the wiring conductor of the second layer 120, as shown in FIG. 3. This applies similarly to a wiring conductor forming a solid copper foil (solid wiring region) of the third layer 130, which functions as a power supply wire.

Further, the wiring conductor of the fourth layer 140 functions as a normal wire, and as shown in FIG. 3, the conductor is removed only from the part positioned below and facing the empty space in the lamination direction of the respective layers such that the wiring conductor of the fourth layer 140 forms a partially cut-away notch.

By removing the wiring conductor from the part positioned directly below the empty space in the lamination direction of the respective layers as described above, it is possible to ensure that the capacitor that would be formed between the wiring conductor and the lower surface of the shunt resistor 12 on either side of the dielectric sealing material 170 charged into the empty space if the wiring conductor existed in this part is not formed.

Note that the range of the parts of the second layer 120 to the fourth layer 140 that are positioned directly below the empty space in the lamination direction of the respective layers does not have to match the region positioned directly below the empty space completely accurately, and may be formed wider than the range positioned directly below the empty space, in which the possibility of capacity formation exists. Moreover, if a capacitance value of the formed capacitor is small enough to pose no problems, the range positioned directly below the empty space can be reduced.

Further, the wiring conductors of the second layer 120 to the fourth layer 140 are shaped such that only the parts thereof positioned directly below the empty space in the lamination direction of the respective layers are removed, but as long as the conductor does not exist in the part positioned directly below the empty space, the capacitor described above is not formed. It is therefore possible for all or a part of the wiring conductors of the second layer 120 to the fourth layer 140 in the vicinity of the part positioned directly below the empty space to be omitted from an original wiring design. For example, the wires forming the fourth layer 140 may all pass positions removed from the range positioned directly below the empty space.

Furthermore, the multilayer circuit board 100 may be formed with a plurality of the current detecting shunt resistors 12, and the shunt resistor 12 may be replaced by another electronic component that may form the aforementioned capacitor, or in other words an electronic component that includes a conductor having a surface substantially parallel to the top surface of the multilayer circuit board 100.

As described above, the multilayer circuit board 100 serving as a motor driving circuit board is structured such that the conductors of the second layer 120, third layer 130, and fourth layer 140, which serve as the conductor layers provided below the space (empty space) to be occupied by the sealing material 170 when charged onto the lower surface of the shunt resistor 12, do not exist in the part facing this empty space. With this structure, it is possible to ensure that the capacitor described above is not formed between the conductor and the shunt resistor 12 without attaching a new component such as an inflow prevention tool for preventing the sealing material 170 from entering the empty space. Moreover, the capacitor is not formed regardless of the manner in which the sealing material 170 is charged into the empty space, and therefore an accurate current detection signal can be obtained reliably.

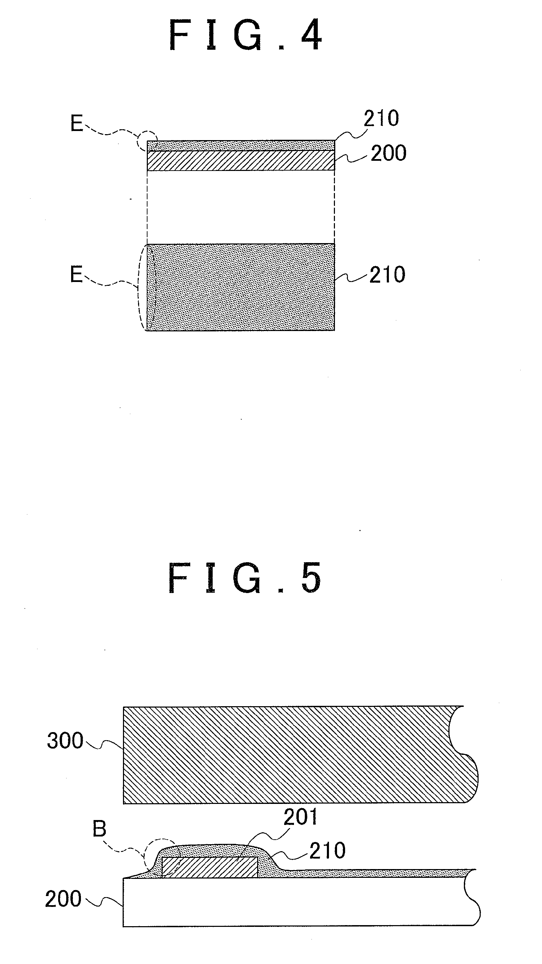

A circuit board having a normal metallic base is used as a circuit board for controlling a current exceeding several tens of amperes, for example, such as the multilayer circuit board 100 described above, which is a motor driving circuit board used in an electric power steering apparatus. This type of circuit board requires a process for compression-bonding the metallic base to a printed board, but in this process, a resist film formed on the top surface of the printed board to protect the circuit may partially peel away. In particular, when the metallic base is compression-bonded to a multilayer circuit board, the multilayer circuit board is thick and the pressure required for the compression bonding is great, and therefore the resist film is particularly likely to peel away. This peeling of the resist film will now be described in detail with reference to FIGS. 4 and 5.

FIG. 4 is a schematic sectional view and a schematic plan view of a multilayer circuit board formed with a resist film, and FIG. 5 is a view illustrating how a resist film is likely to peel away from the vicinity of a circuit conductor in a multilayer circuit board during a compression bonding process.

As shown in FIG. 4, a resist film 210 functioning as solder resist is formed on a multilayer circuit board 200. The resist film 210 is applied to the multilayer circuit board 200 using a well-known method such as a spraying method or a curtain method, and then hardened. When a metallic base made of aluminum or the like is compression-bonded to the multilayer circuit board 200 using a thermal compression bonding apparatus or the like, the resist film is particularly likely to peel away from end portions of the substrate, i.e. regions surrounded by dotted lines E in FIG. 4, for example. A possible reason for this is that in the vicinity of the end portions of the wiring conductors provided near the substrate end portions, the thickness of the resist film is more likely to decrease and the resist film is more likely to take a distorted sectional shape including a projecting portion.

More specifically, as shown in FIG. 5, the resist film 210 is formed on a wiring conductor 201 provided near an end portion of the multilayer circuit board 200, but the resist film 210 formed on a substrate end portion-side end portion of the wiring conductor 201 is particularly thin and has a distorted sectional shape, as shown by the region surrounded by a dotted line B in FIG. 5, for example. A possible reason for this is that the end portion of the multilayer circuit board 200 is close to the end portion of the wiring conductor 201, and therefore, during application, the resist film 210 cannot be stretched gently while maintaining sufficient thickness. Here, the metallic base, not shown in the drawings, is thermal compression-bonded to the lower surface of the multilayer circuit board 200, and therefore, when pressure is applied to the multilayer circuit board 200 by a pressing upper plate 300 of the thermal compression bonding apparatus from the upper side of the drawing toward the lower side of the drawing, stress concentrates in the part of the resist film 210 having the sectional shape described above. As a result, the resist film 210 may peel away.

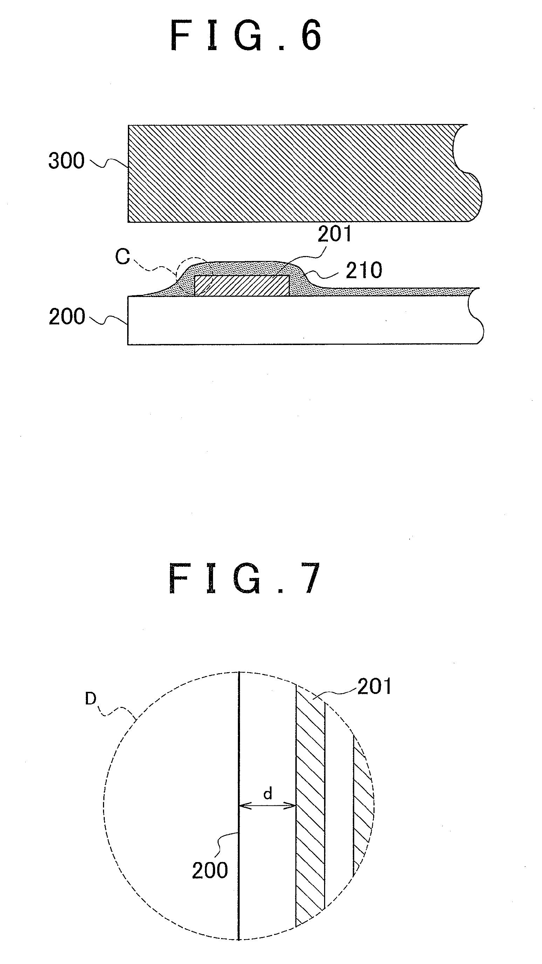

By increasing the distance between the end portion of the multilayer circuit board 200 and the end portion of the wiring conductor 201 so that the resist film 210 stretches gently while maintaining sufficient thickness, the resist film 210 can be made less likely to peel away near the end portion. This will now be described with reference to FIGS. 6 to 8.

FIG. 6 is a view illustrating how a resist film is unlikely to peel away from the vicinity of a circuit conductor in a multilayer circuit board according to a modified example of this embodiment during a compression bonding process. FIG. 7 is a plan view showing a substrate end portion and a wiring conductor according to a modified example of this embodiment. FIG. 8 is a plan view showing a substrate end portion and a wiring conductor according to another modified example of this embodiment.

As shown in FIG. 6, an end portion position of the wiring conductor 201 that is closest to the end portion of the multilayer circuit board 200 is farther removed from the end portion of the multilayer circuit board 200 than the conventional position shown in FIG. 5. Hence, the resist film 210 formed on the substrate end portion-side end portion of the wiring conductor 201, which is illustrated as a region surrounded by a dotted line C in FIG 6, for example, is not excessively thin and does not have a distorted sectional shape. The reason for this is that the end portion of the multilayer circuit board 200 is comparatively removed from the end portion of the wiring conductor 201, and therefore, during application, the resist film 210 can be stretched gently while maintaining sufficient thickness.

Thus, the resist film 210 is less likely to peel away. However, when a resist material having a typical composition is used, this distance, or in other words a distance d between the end portion of the multilayer circuit board 200 and the end portion of the wiring conductor 201 shown in FIG. 7, is preferably set at no less than at least 1 mm. In so doing, the resist film 210 can be stretched gently while maintaining sufficient thickness during application.

Further, the width of the wiring conductor 201, i.e. the length of a perpendicular direction to the direction in which the side of the substrate end portion extends along the substrate surface, is preferably as long as possible. In other words, the wiring conductor 201 is preferably formed from solid copper foil. The reason for this is that when the width of the wiring conductor 201 is small, the cross-section of the resist film 210 on the wiring conductor 201 takes a sharp curved shape, but when the width of the wiring conductor 201 is great, it is easy to stretch the resist film 210 gently while maintaining sufficient thickness.

Thus, the resist film 210 is less likely to peel away. However, when a resist material having a typical composition is used, this width, or in other words a width w of the solid copper foil forming the wiring conductor 201 shown in FIG. 8, is preferably set at no less than at least 2 mm. In so doing, the resist film 210 can be stretched gently while maintaining sufficient thickness during application.
A multilayer circuit board (100) serving as a motor driving circuit board is structured such that conductors of a first layer (110), a second layer (120), a third layer (130), and a fourth layer (140), which serve as conductor layers provided below an empty space to be occupied by a sealing material (170) when the sealing material (170) is charged onto a lower surface of a shunt resistor (12) serving as an electronic component having a large conductor surface, do not exist in a part facing the empty space. With this structure, it is possible to ensure that a capacitor is not formed between the circuit board (100) and the shunt resistor (12) without the need for an inflow prevention tool. As a result, an accurate current detection signal can be obtained reliably.

## Claims

1. A multilayer circuit board (100) formed by laminating conductor layers (110, 120, 130, 140) and insulating layers (150) alternately, **characterized by** comprising:
a conductor (12) that has a surface substantially parallel to a top surface of the multilayer circuit board (100), and that is connected to an uppermost conductor layer (110) such that a gap is formed between the conductor (12) and the top surface of the multilayer circuit board (100); and
a sealing material (170) serving as a dielectric that is charged into a space including a periphery of the conductor (12) and the gap,
wherein, in the conductor layers (110, 120, 130, 140), a conductor is not formed in a position facing the gap in a lamination direction of the conductor layers (110, 120, 130, 140) and the insulating layers (150).

2. The multilayer circuit board (100) according to claim 1, wherein
in at least one of the conductor layers (110, 120, 130, 140), a part facing the gap in the lamination direction of the conductor layers (110, 120, 130, 140) and the insulating layers (150) is removed.

3. The multilayer circuit board (100) according to claim 2, wherein
in all of the conductor layers (110, 120, 130, 140), the part facing the gap in the lamination direction of the conductor layers (110, 120, 130, 140) and the insulating layers (150) is removed.

4. The multilayer circuit board (100) according to claims 2 or 3, wherein
the part of the conductor layer (110, 120, 130, 140) is removed to form a hole in the conductor layer (110, 120, 130, 140).

5. The multilayer circuit board (100) according to claims 2 or 3, wherein
the part of the conductor layer (110, 120, 130, 140) is removed to form a notch in the conductor layer (110, 120, 130, 140).

6. The multilayer circuit board (100) according to any one of claims 1 to 5, wherein
the conductor (12) is connected to the uppermost conductor layer (110) via solder (105), and
the gap is formed in a region surrounded by the conductor (12), the solder (105), and the top surface of the multilayer circuit board (100).

7. The multilayer circuit board (100) according to any one of claims 1 to 6, wherein
the conductor (12) is a current detecting resistor.

8. A motor driving circuit board (100) for an electric power steering apparatus, which is formed by laminating conductor layers (110, 120, 130, 140) and insulating layers (150) alternately, **characterized by** comprising:
a current detecting resistor (12) that has a surface substantially parallel to a top surface of the motor driving circuit board (100), and that is connected to an uppermost conductor layer (110) such that a gap is formed between the current detecting resistor (12) and the top surface of the motor driving circuit board (100); and
a sealing material (170) serving as a dielectric that is charged into a space including a periphery of the resistor (12) and the gap,
wherein, in the conductor layers (110, 120, 130, 140), a conductor is not formed in a part facing the gap in a lamination direction of the conductor layers (110, 120, 130, 140) and the insulating layers (150).
